(19) Europäisches Patentamt
European Patent Office
Office européen des brevets

(11) EP 1 000 464 B1

(12) **EUROPÄISCHE PATENTSCHRIFT**

(45) Veröffentlichungstag und Bekanntmachung des Hinweises auf die Patenterteilung:
**10.04.2002 Patentblatt 2002/15**

(21) Anmeldenummer: **98943792.6**

(22) Anmeldetag: **28.07.1998**

(51) Int Cl.$^7$: **H03F 1/32**

(86) Internationale Anmeldenummer:
**PCT/EP98/04717**

(87) Internationale Veröffentlichungsnummer:
**WO 99/05784 (04.02.1999 Gazette 1999/05)**

(54) **MESSVERFAHREN UND MESSEINRICHTUNG ZUM MESSEN DER VERZERRUNG EINES HOCHFREQUENZ-LEISTUNGSVERSTÄRKERS UND ENTZERRUNGSVERFAHREN UND ENTZERRUNGSEINRICHTUNG**

MEASURING METHOD AND DEVICE FOR MEASURING THE DISTORTION OF A HIGH FREQUENCY POWER AMPLIFIER AND CORRECTION METHOD AND DEVICE FOR THE AUTOMATIC CORRECTION OF A HIGH FREQUENCY POWER AMPLIFIER

PROCEDE ET DISPOSITIF DE MESURE POUR LA MESURE DE LA DISTORSION D'UN AMPLIFICATEUR DE PUISSANCE HAUTE FREQUENCE, AINSI QUE PROCEDE ET DISPOSITIF DE CORRECTION POUR LA CORRECTION AUTOMATIQUE D'UN AMPLIFICATEUR DE PUISSANCE HAUTE FREQUENCE

(84) Benannte Vertragsstaaten:
**AT DE FI FR GB IT NL SE**

(30) Priorität: **28.07.1997 DE 19732465**
**27.03.1998 DE 19813703**

(43) Veröffentlichungstag der Anmeldung:
**17.05.2000 Patentblatt 2000/20**

(73) Patentinhaber: **Rohde & Schwarz GmbH & Co. KG**
**D-81671 München (DE)**

(72) Erfinder: **BAUER, Helmut**
**D-83629 Weyarn (DE)**

(74) Vertreter: **Graf, Walter, Dipl.-Ing.**
**Mitscherlich & Partner**
**Patent- u. Rechtsanwälte,**
**Sonnenstrasse 33**
**80331 München (DE)**

(56) Entgegenhaltungen:
**EP-A- 0 289 130**

- **MOHAMMAD GHADERI ET AL: "POWER AMPLIFIER ADAPTIVE LINEARIZATION USING PREDISTORTION WITH POLYNOMIAL FUNCTIONS" PROCEEDINGS OF THE EUROPEAN MICROWAVE CONFERENCE, ESPOO, FINLAND, AUG. 24 - 27, 1992, Bd. 2, Nr. CONF. 22, 24. August 1992, Seiten 1125-1130, XP000337878 MICROWAVE EXHIBITIONS AND PUBLISHERS**
- **BELLIS M: "AN ENERGY EFFICIENT UHF POWER AMPLIFIER FOR EXISTING AND PROPOSED TRANSMISSION SYSTEMS" BROADCAST SESSIONS, MONTREUX, JUNE 10 - 15, 1993, Nr. SYMP. 1993, 10. Juni 1993, Seiten 739-747, XP000385327 POSTES;TELEPHONES ET TELEGRAPHES SUISSES**

EP 1 000 464 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die Erfindung betrifft ein Meßverfahren zum Messen der Verzerrung eines Hochfrequenz-Leistungsverstärkers und eine entsprechende Meßeinrichtung. Ferner betrifft die Erfindung ein Entzerrungsverfahren zum automatischen Entzerren eines Hochfrequenz-Leistungsverstärkers und eine entsprechende Entzerrungseinrichtung.

Hochfrequenz-Leistungsverstärker weisen üblicherweise eine nicht vollständig lineare Kennlinie auf. Es kommt daher zu einer Verzerrung des durch den Hochfrequenz-Leistungsverstärker verstärkten Hochfrequenzsignals. Durch die Nichtlinearitäten des Hochfrequenz-Leistungsverstärkers entsteht ein unerwünschtes Störspektrum. Bei Multiträgersignalen, wie sie bei der digitalen Übertragung von Audio- und Videosignalen Verwendung finden, äußert sich das Störspektrum in außerhalb des Übertragungsbandes liegenden Außerbandstörungen und in innerhalb des Übertragungsbandes liegenden Inbandsstörungen. Um eine einwandfreie Übertragung des Multiträgersignals zu gewährleisten, muß das Störspektrum einen vorgegebenen Pegelabstand von dem Nutzsignal aufweisen. An die Linearität des Hochfrequenz-Leistungsverstärkers in der Endstufe eines Verstärkers für DAB(Digital Audio Broadcasting)-Signale und DVB (digital video broadcasting)-Signale sind daher relativ hohe Anforderungen zu stellen.

Bisher war es beim Abgleich derartiger Hochfrequenz-Leistungsverstärker üblich, dem Eingang ein Multiträger-Abgleichsignal zuzuführen und das Ausgangssignal des Hochfrequenz-Leistungsverstärkers mit einem Spektrum-Analysator zu beobachten. In dem Signalweg vor dem Hochfrequenz-Leistungsverstärker wurde eine Vorverzerrungseinrichtung angeordnet, die eine Vorverzerrung des zu verstärkenden Hochfrequenzsignal erlaubt. Die Vorverzerrungskennlinie ist z. B. durch ein Dioden-Widerstandsnetzwerk mit veränderlichen Widerständen festgelegt, so daß der Kurvenverlauf der Vorentzerrungskennlinie durch eine Vielzahl von Parametern variabel einstellbar ist. Durch Verstellen der Einstellungsparameter des Vorverzerrungsnetzwerks wurde dann iterativ versucht, einen möglichst großen Schulterabstand zwischen dem Nutzsignal und dem Störsignal in dem Ausgangsspektrum des Hochfrequenz-Leistungsverstärkers zu erreichen. Da es keine Strategie für die Einstellung der einzelnen Parametern des Vorverzerrungsnetzwerks gibt und sich die Einstellungen der einzelnen Parameter gegenseitig beeinflussen, ist diese Vorgehensweise äußerst zeitaufwendig und somit kostenaufwendig. Ferner ist eine einmal gefundene Einstellung von der Temperatur, der Alterung der Bauelemente des Hochfrequenz-Leistungsverstärkers und anderen Einflüssen abhängig.

Es ist daher die Aufgabe der vorliegenden Erfindung ein geeignetes Meßverfahren zum Messen der Verzerrung eines Hochfrequenz-Leistungsverstärkers und ein geeignetes Entzerrungsverfahren zum automatischen Entzerren eines Hochfrequenz-Leistungsverstärkers sowie eine entsprechende Meßeinrichtung und eine entsprechende Entzerrungseinrichtung anzugeben.

Die Aufgabe wird hinsichtlich des Meßverfahrens durch die Merkmale des Anspruchs 1, hinsichtlich des Entzerrungsverfahrens durch die Merkmale des Anspruchs 8, hinsichtlich der Meßeinrichtung durch die Merkmale des Anspruchs 16 und hinsichtlich der Entzerrungseinrichtung durch die Merkmale des Anspruchs 17 gelöst.

Das erfindungsgemäße Meßverfahren nach Anspruch 1 hat den Vorteil, daß die Aussteuer-Kennlinie des Hochfrequenz-Leistungsverstärkers umittelbar angezeigt wird. Der Operator hat daher bei dem Abgleich des Hochfrequenz-Leistungsverstärkers bzw. einer vor dem Hochfrequenz-Leistungsverstärker angeordneten Vorverzerrungseinrichtung ein wirksames Abgleichkriterium, nämlich eine möglichst weitgehende Linearisierung der Aussteuerkennlinie zu erreichen.

Die Ansprüche 2 bis 7 beinhalten vorteilhafte Weiterbildungen des erfindungsgemäßen Meßverfahrens.

Vorteilhafterweise erfolgt die Erzeugung der Ausgangs-Hüllkurve und der Eingangs-Hüllkurve entsprechend den Ansprüchen 2 und 3 mittels Synchrondemodulation. Zur Anzeige des Phasenwinkels entsprechend den Ansprüchen 4 und 5 wird von der Ausgangs-Hüllkurve sowohl eine Inphase-Komponente als auch eine Quadratur-Komponente erzeugt. Aus dem Verhältnis dieser beiden Komponenten läßt sich der Phasenwinkel des Ausgangssignals ermitteln. Vorteilhafterweise erfolgt die Synchrondemodulation der Inphase-Komponente und der Quadratur-Komponente entsprechend Anspruch 6 in getrennten Synchrondemodulatoren. Vorzugsweise wird ferner entsprechend Anspruch 7 der Referenzträger einer Phasenverschiebung unterworfen, die der Signallaufzeitverzögerung durch den Hochfrequenz-Verstärker entspricht.

Der Vorteil des erfindungsgemäßen Entzerrungsverfahrens nach Anspruch 8 besteht darin, daß in einem Abgleichmodus durch ein geeignetes Abgleichsignal ein Amplituden-Korrekturfaktor für das Eingangsignals des Hochfrequenz-Leistungsverstärkers gewonnen wird und das Eingangssignal einer automatischen Amplitudenvorverzerrung unter Berücksichtigung des Amplituden-Korrekturfaktors unterworfen wird. Der Abgleich der Vorverzerrungseinrichtung erfolgt automatisch, wodurch sich der Zeitaufwand für die Inbetriebnahme wesentlich verringert.

Die Ansprüche 9 bis 15 beinhalten vorteilhafte Weiterbildungen des erfindungsgemäßen Entzerrungsverfahrens.

Vorzugsweise wird entsprechend Anspruch 9 zusätzlich ein Phasen-Korrekturfaktor gewonnen und das Eingangssignal einer automatischen Phasenvorverzerrung unter Verwendung des Phasen-Korrekturfaktors unterworfen.

Entsprechend Anspruch 11 werden der Amplituden-Korrekturfaktor und ggf. der Phasen-Korrekturfaktor einer Vorverzerrungseinrichtung zugeführt, deren Aussteuer-Kennlinie und ggf. Phasen-Kennlinie invers zu der Aussteuer-Kennlinie und Phasen-Kennlinie des Hochfrequenz-Verstärkers automatisch eingestellt werden. Dazu werden vorzugsweise entsprechend Anspruch 12 die Eingangs-Hüllkurve und die Ausgangs-Hüllkurve digitalisiert und zur Berechnung des Amplituden-Korrekturfaktors und ggf. des Phasen-Korrekturfaktors einem Steuerrechner zugeführt.

Als Abgleichsignal kann in besonders einfacher Weise entsprechend Anspruch 13 ein amplitudenmoduliertes Einfachträgersignal dienen. Ein anderes besonders geeignetes Abgleichsignal ist ein Multiträgersignal entsprechend Anspruch 14, bei welchem sich sämtliche Träger im gleichen Phasenzustand befinden. Dieses Abgleichsignal kommt dem Nutzsignal relativ nahe, weist jedoch keine Phasenschwankungen auf und ist daher für den Abgleich besonders geeignet. Grundsätzlich kommt als Abgleichsignal jedoch auch das Nutzsignal in Betracht.

Wenn der Hochfrequenz-Leistungsverstärker modular aus mehreren parallel angeordneten, baugleichen Teilverstärkern zusammengesetzt ist, ist es nach Anspruch 15 ausreichend, nur einen der Teilverstärker mit dem erfindungsgemäßen Entzerrungsverfahren abzugleichen und die Vorverzerrungsfaktoren für die Eingangssignale der anderen Teilverstärker in gleicher Weise zu übernehmen.

Ein Ausführungsbeispiel der Erfindung ist nachfolgend unter Bezugnahme auf die Zeichnung näher beschrieben. In der Zeichnung zeigen:

Fig. 1 ein Blockschaltbild der erfindungsgemäßen Meßeinrichtung und der erfindungsgemäßen Entzerrungseinrichtung,

Fig. 2 die Aussteuerkennlinie eines nicht entzerrten Hochfrequenz-Leistungsverstärkers,

Fig. 3 die Phasen-Kennlinie eines nicht entzerrten Hochfrequenz-Leistungsverstärkers,

Fig. 4 ein Multiträger-Eingangssignal eines nicht entzerrten Hochfrequenz-Leistungsverstärkers,

Fig. 5 das Ausgangsfrequenzspektrum eines nicht entzerrten Hochfrequenz-Leistungsverstärkers bei dem in Fig. 4 dargestellten Multiträger-Eingangssignal,

Fig. 6 die Aussteuerkennlinie des nicht entzerrten Hochfrequenz-Leistungsverstärkers bei dem Multiträger-Eingangssignal entsprechend Fig. 4,

Fig. 7 die Phasenkennlinie des nicht entzerrten Hochfrequenz-Leistungsverstärkers bei dem Multiträger-Eingangssignal entsprechend Fig. 4,

Fig. 8 die vorverzerrte Hüllkurve des in Fig. 4 dargestellten Multiträger-Eingangssignals bei einer Amplituden-Vorverzerrung,

Fig. 9 das Ausgangsspektrum des Hochfrequenz-Leistungsverstärkers bei einem in der Amplitude vorverzerrten Multiträger-Einganssignal,

Fig. 10 die Aussteuer-Kennlinie des Hochfrequenz-Leistungsverstärkers bei einem in der Amplitude vorverzerrten Multiträger-Eingangssignal.

Fig. 11 das Ausgangsspektrum des Hochfrequenz-Leistungsverstärkers bei einem Multiträger-Einganssignal, das sowohl in der Amplitude als auch in der Phase vorverzerrt ist,

Fig. 12 die Phasenkennlinie des Hochfrequenz-Leistungsverstärkers bei einem Multiträger-Eingangssignal, das sowohl in der Amplitude als auch in der Phase vorverzerrt ist, und

Fig. 13 ein Ersatzschaltbild des Hochfrequenz-Leistungsverstärkers.

Fig. 1 zeigt ein Blockschaltbild der erfindungsgemäßen Meßeinrichtung zum Messen der Verzerrung eines Hochfrequenz-Leistungsverstärkers. In dem gleichen Blockschaltbild sind auch die zusätzlichen Komponenten für die erfindungsgemäße Entzerrungseinrichtung zum automatischen Entzerren des Hochfrequenz-Leistungsverstärkers dargestellt.

Ein von einer Signalquelle 1 erzeugtes Abgleichsignal wird über eine Vorverzerrungseinrichtung 2 dem Eingang eines Hochfrequenz-Leistungsverstärkers 3 zugeführt. An dem Ausgang des Hochfrequenz-Leistungsverstärkers 3 befindet sich ein Lastwiderstand 4, z. B. der Speisewiderstand einer Sendeantenne. Wie in Fig. 1 schematisch verdeutlicht, hat der Leistungsverstärker baulich bedingt eine nicht vollständig linearisierte Aussteuerkennlinie und eine Phasenkennlinie. Als Aussteuerkennlinie wird im folgenden die Ausgangsleistung des Hochfrequenz-Leistungsverstärkers als Funktion seiner Eingangsleistung verstanden. Die Aussteuerkennlinie läßt sich jedoch auch als Ausgangsamplitude als Funktion der Eingangsamplitude definieren. Als Phasenkennlinie wird im folgenden die Ausgangsphasenkennlinie, d. h. die Ausgangsphase des Hochfrequenz-Leistungsverstärkers als Funktion seiner Ausgangsleistung verstanden. Die Phasenkennlinie läßt sich auch als Ausgangsphase als Funktion der Ausgangsamplitude der Funktion der Eingangsleistung oder Eingangsamplitude definieren.

Sowohl das Eingangssignal 7 des Hochfrequenz-Leistungsverstärkers 3 als auch das Ausgangssignal 6 des Hochfrequenz-Leistungsverstärkers werden gemessen und der erfindungsgemäßen Meßeinrichtung 5 zugeführt. Das Eingangssignal 7 wird zunächst in die Eingangs-Hüllkurve und den Referenzträger aufgeteilt. Dabei wird davon ausgegangen, daß sich das Eingangssignal $U_E$ (t) als Produkt der Eingangs-Hüllkurve $U_{HE}$ (t) und eines Winkelmodulationsanteils darstellen läßt:

$$U_E\,(t) = U_{HE}\,(t)\,\sin\,(\omega t + \varphi\,(t))$$

Die Eingangs-Hüllkurve $U_{HE}$ (t) läßt sich daher mittels eines ersten Synchrondemodulators 8erzeugen, welchem der von dem Eingangssignal separierte Referenzträger und das Eingangssignal $U_E$ (t) zugeführt werden.

In entsprechender Weise wird das Ausgangssignal einem zweiten Synchrondemodulator 9 und einem dritten Synchrondemodulator 10 zugeführt. Der Referenzträger wird vorzugsweise in einem Phasenschieber 11 um einen Phasenbetrag verschoben, der der Signallaufzeit in dem Hochfrequenz-Leistungsverstärker 3 entspricht. In dem zweiten Synchrondemodulator 9 erfolgt eine Synchrondemodulation mit dem gemessenen Ausgangssignal 6 und dem um die Signallaufzeit phasenverschobenen Referenzträger. Das Ausgangsignal des Synchrondemodulators 9 ist eine Inphase-Komponente der Hüllkurve des Ausgangssignals. Das Ausgangssignal des ersten Phasenschiebers 11 wird einem zweiten Phasenschieber 12 zugeführt, der den Referenzträger zusätzlich um 90° in der Phase verschiebt. Dem dritten Synchrondemodulator 10 wird das gemessene Ausgangssignal 6 und der um 90° zusätzlich phasenverschobene Referenzträger zugeführt, so daß der dritte Synchrondemodulator 10 eine Quadratur-Komponente der Hüllkurve des Ausgangssignals erzeugt.

Die Synchrondemodulatoren 8 und 9 können zur Vereinfachung bzw.. aus Kostengründen auch durch Hüllkurvengleichrichter ersetzt werden.

An einer ersten Anzeigeeinrichtung 13, z. B. einem Oszillographen, einem Speicheroszillographen oder einem Computerbildschirm, wird die Amplituden-Kennlinie des Hochfrequenz-Leistungsverstärkers 3 dargestellt. Dazu wird einem x-Eingang 14 der ersten Anzeigeeinrichtung 13 die durch den ersten Synchrondemodulator 8 gewonnene Eingangs-Hüllkurve und dem y-Eingang der ersten Anzeigeeinrichtung 13 die durch den zweiten Synchrondemodulator 9 gewonnene Inphasen-Komponente der Ausgangs-Hüllkurve zugeführt. Dargestellt wird daher die Ausgangsamplitude des Hochfrequenz-Leistungsverstärkers 3 als Funktion der Eingangsamplitude des Hochfrequenz-Leistungsverstärkers 3. Wenn anstatt der Amplituden-Kennlinie die Aussteuerkennlinie des Hochfrequenz-Leistungsverstärkers 3 in der Form dargestellt werden soll, daß die Ausgangsleistung des Hochfrequenz-Leistungsverstärkers als Funktion der Eingangsleistung aufgezeigt wird, so sind die Eingangsignale an den Eingängen 14 und 15 durch entsprechende, nicht dargestellte Quadrierglieder in der Amplitude zu Quadrieren.

Die durch den dritten Synchrondemodulator 10 erzeugte Quadratur-Komponente der Ausgangs-Hüllkürve dient zusammen mit der durch den zweiten Synchrondemodulator 9 erzeugten Inphase-Komponente zur Erzeugung der Phasen-Kennlinie. Dazu wird in einer Einrichtung 16 der Phasenwinkel β mittels der nachfolgenden Gleichung analog oder digitaler ermittelt:

$$\beta\,(t) = \arctan\,(U_{Quadratur} / U_{Inphase})$$

Dabei stellt die Quadratur-Komponente $U_{Quadratur}$ den Imaginärteil der Ausgangs-Hüllkurve und die Inphase-Komponente $U_{Inphase}$ den Realteil der Ausgangs-Hüllkurve dar, so daß mit der Formel (2) der Ausgangsphasenwinkel β berechnet werden kann. Der so gewonnene Ausgangsphasenwinkel wird dem y-Eingang 17 einer zweiten Anzeigevorrichtung 18 zugeführt. Dem x-Eingang 19 der zweiten Anzeigeeinrichtung 18 wird die durch den ersten Synchrondemodulator 8 erzeugte Eingangs-Hüllkurve zugeführt. In den in den Fig. 3, 7 und 12 dargestellten Diagrammen ist die Ausgangsphase β als Funktion der Ausgangsleistung dargestellt. Dazu ist dem x-Eingang der zweiten Anzeigevorrichtung 18 die in einem nicht dargestellten Quadrierglied quadrierte Inphase-Komponente der Ausgangs-Hüllkurve zuzuführen.

Das erfindungsgemäße Meßverfahren bzw. die erfindungsgemäße Meßeinrichtung 5 gestattet es dem Operator eine Einstellung der Vorverzerrungseinrichtung 2 so vorzunehmen, daß die Aussteuer-Kennlinie bzw. die Amplituden-Kennlinie möglichst linear verläuft und die durch den Hochfrequenz-Leistungsverstärker 3 hervorgerufene Phasenverschiebung für alle Amplituden des Eingangssignal bzw. für alle Ausgangsleistungen möglichst konstant, vorzugsweise Null, ist. Dabei ist die Summe der Amplitudenverzerrungen durch die Vorverzerrungseinrichtung 2 und den Hochfrequenz-Leistungsverstärker 3 und die Summe der Phasenverzerrung durch die Vorverzerrungseinrichtung 2 und den Hochfrequenz-Leistungsverstärker 3 möglichst gering. Dies erlaubt dem Operator eine zügige Einstellung der Vorverzerrungseinrichtung 2 unter Berücksichtigung der vorstehend genannten Abgleichkriterien. Der Abgleich der Vorverzerrungseinrichtung 2 erfolgt wesentlich zügiger und zielgerichteter als bei der alleinigen Beobachtung des Schulterabstands zwischen dem Nutzsignal und dem Störsignal im Ausgangsspektrum des Hochfrequenz-Leistungsverstärkers 3. Selbstverständlich kann das Ausgangsspektrum des Hochfrequenz-Leistungsverstärkers 3 auch bei der erfindungsgemäßen Vorgehensweise als zusätzliches Kriterium herangezogen werden.

Die Einstellung der Vorverzerrungseinrichtung 2 muß jedoch nicht notwendigerweise manuell nach den vorstehend beschriebenen Abgleichkriterien erfolgen sondern kann mittels des erfindungsgemäßen Entzerrungsverfahrens und der aus der bereits beschriebenen Meßeinrichtung 5 und der Vorverzerrungseinrichtung 20 bestehenden erfindungsgemäßen Entzerrungseinrichtung 5, 20 auch automatisch erfolgen.

In dem in Fig. 1 dargestellten Ausführungsbeispiel werden daher die Eingangs-Hüllkurve in einem ersten Analog/Digital-Wandler 21, die Inphase-Komponente der Ausgangs-Hüllkurve in einem zweiten Analog/Digital-Wandler und die Quadratur-Komponente der Ausgangs-Hüllkurve in einem dritten Analog/Digital-Wandler 23 digitalisiert. Die digitalisierten Hüllkurvensignale werden einem Steuerrechner 24 zur Durchführung einer digitalen Signalverarbeitung zugeführt. Der Steuerrechner 24 berechnet einen Amplituden-Korrekturfaktor und/oder einen Phasen-Korrekturfaktor, mit welchen das Nutzeingangssignal in der Vorverzerrungseinrichtung 2 multipliziert und dadurch vorverzerrt wird.

Der von der Amplitude des Eingangssignals abhängige Amplituden-Korrekturfaktor wird in einfacher Weise dadurch gewonnen, daß die Umkehrfunktion der mittels der Meßeinrichtung 5 gewonnen Amplituden-Kennlinie erzeugt wird. Die Amplituden-Kennlinie der Vorverzerrungseinrichtung 2 ist daher invers zu der Amplituden-Kennlinie des Hochfrequenz-Leistungsverstärkers 3, was in Fig. 1 schematisch angedeutet ist. Die Umkehrfunktion kann dadurch in einfacher Weise erzeugt werden, das in einem Speicher die Eingangswerte und die Ausgangswerte vertauscht werden. Um eine eindeutige Zuordnung der Eingangswerte zu den Ausgangswerten zu erreichen, kann vorher die Amplituden-Kennlinie an vorgegebenen Stützstellen abgetastet und gemittelt werden und nachfolgend einer Interpolation unterzogen werden.

Der Phasen-Korrekturfaktor ist $e^{-i\beta}$, wobei $\beta$ die mittels der Meßeinrichtung 5 gewonnene Ausgangsphase des Hochfrequenz-Leistungsverstärkers 3 als Funktion der Amplitude des Eingangssignals ist. Anstatt einer digitalen Ansteuerung der Vorverzerrungseinrichtung 2 kann die Ansteuerung selbstverständlich auch mittels eines analogen Netzwerkes erfolgen.

Der Vorteil der automatischen Erzeugung der Vorverzerrungskennlinie für die Vorverzerrungseinrichtung 2 besteht darin, daß ein automatischer Abgleich bei Inbetriebnahme des Hochfrequenz-Leistungsverstärkers 3 relativ rasch durchgeführt werden kann und bei Bedarf die Vorverzerrungskennlinie von Zeit zu Zeit automatisch nachgestellt werden kann, wenn sich z. B. die Betriebstemperatur des Hochfrequenz-Leistungsverstärkers 3 ändert oder die Bauteile, insbesondere das aktive Verstärkungselement, des Hochfrequenz-Leistungsverstärkers 3 aufgrund einer Alterung sich in ihre Kennlinie verändern.

Als Abgleichssignal kann im Abgleichmodus grundsätzlich das Nutzsignal dienen. Vorteilhafterweise wird jedoch ein spezielles Abgleichsignal, z. B. ein amplitudenmodulierter Einfachträger oder ein schmalbandiges Multiträger-Signal verwendet, bei welchem sich sämtliche Träger in einem definierten, vorzugsweise dem gleichen Phasenzustand befinden. Wenn der Hochfrequenz-Leistungsverstärker 3 aus mehreren parallel angeordneten, baugleichen Teilverstärker modular aufgebaut ist. kann der Abgleich auch nur an einem einzigen Teilverstärker vorgenommen werden und die gewonnenen Vorverzerrungskennlinien für die zugeordnete Vorverzerrungseinheit 2 für die jeweils anderen Teilverstärker übernommen werden.

Zum besseren Verständnis der Erfindung und zur Darstellung der Wirkungsweise der Erfindung sind in den Fig. 2 bis 12 mehrere Simulationsergebnisse dargestellt, die durch Meßergebnisse an einem realen Hochfrequenz-Leistungsverstärker 3 verifiziert wurden. Bei der Simulation des Hochfrequenz-Leistungsverstärkers 3 wurde von dem in Fig. 13 dargestellten Ersatzschaltbild ausgegangen. Das Signal A (t) der Eingangssignalquelle 30 wird über ein Widerstandsnetzwerk Ri und Rein auf ein Verstärkungselement 31 gegeben. Über die Kapazität Crü erfolgt eine Rückkopplung von dem Ausgang auf den Eingang des Verstärkungselements 31. Das Ausgangsnetzwerk des Hochfrequenz-Leistungsverstärkers 3 besteht aus drei als $\pi$-Filter zusammengeschaltete Schwingkreise 32, 33 und 34, wobei die Schwingkreise 32 und 34 als Parallelschwingkreise und der Schwingkreis 33 als Serienschwingkreis ausgebildet sind. Die Schwingkreise 32-33 sind jeweils durch ihre Mittenfrequenzen f01p, f0k, f02p und ihre Güten Q1p, Qk und Q2p charakterisiert.

Fig. 2 zeigt die Ansteuerkennlinie eines nicht entzerrten Hochfrequenz-Leistungsverstärkers 3, d. h. eines Hochfrequenz-Leistungsverstärkers 3 ohne Vorverzerrungseinrichtung 2. Die Eingangsleistung und die Ausgangsleistung sind jeweils normiert. Fig. 3 zeigt die Phase am Ausgang des Hochfrequenz-Leistungsverstärkers 3 als Funktion der nomierten Ausgangsleistung. Das Eingangssignal des in den Fig. 2 und 3 dargestellten Simulationsbeispiels ist ein Amplitudenmoduliertes Einfachträgersignal.

In Fig. 2 ist deutlich erkennbar, daß die Aussteuer-Kennlinie eine S-förmige Krümmung aufweist und nicht linear ist. Es treten daher erhebliche Amplitudenverzerrungen auf. Die in Fig. 3 dargestellte Phasen-Kennlinie zeigt, daß die Ausgangsphase erheblich von der Ausgangsleistung des Hochfrequenz-Leistungsverstärkers 3 abhängig ist. Es treten daher erhebliche Phasenverzerrungen auf.

In Fig. 4 ist ein Multiträger-Signal mit insgesamt 8 Nutzträgern dargestellt. Die einzelnen Träger sind 4PSKmoduliert und können daher jeweils vier unterschiedliche Phasenzustände einnehmen. Bei dem in Fig. 4 dargestellten Beispielssignal wurde folgende zufällige Verteilung der den einzelnen Trägern zugeordneten Phasen angenommen:

| Frequenz in MHz | Phase |
|---|---|
| 396 | 0 |
| 397 | 0 |
| 398 | π |
| 399 | ½ π |
| 401 | 0 |
| 402 | π |
| 403 | ½ π |
| 404 | 0 |

Fig. 5 zeigt das Ausgangsspektrum des nicht entzerrten Hochfrequenz-Leistungsverstärkers 3, d. h. ohne Vornahme einer Vorverzerrung des Eingangssignals. Obwohl tatsächlich bei DAB- und DVB-Systemen verwendete Multiträgersignale aus bis zu 8000 Trägern zusammengesetzt sind, zeigt die hier vorgenommene Simulation mit nur acht Trägerfrequenzen dennoch die grundsätzliche Wirkungsweise der Erfindung. Bei dem in Fig. 5 dargestellten Ausgangsspektrum zeigt sich, daß, wie erwartet, neben den acht Trägerfrequenzen des Nutzsignals ein Störspektrum auftritt, das gegenüber dem Nutzsignal nur einen Schulterabstand von etwa 18 dB aufweist. Ein derart geringer Schulterabstand ist in der Praxis vollkommen ungenügend.

Fig. 6 zeigt die zugehörige Aussteuer-Kennlinie und Fig. 7 zeigt die zugehörige Phasen-Kennlinie. Auch hier zeigt sich, daß die Aussteuer-Kennlinie große Nicht-Linearitäten aufweist und die Ausgangsphase in erheblichem Maße von der Ausgangsleistung abhängig ist.

Fig. 8 zeigt die mit dem Bezugszeichen 40 versehene unverzerrte Eingangs-Hüllkurve des in Fig. 4 dargestellten Multiträger-Signals. Mit dem Bezugszeichen 41 ist die Eingangs-Hüllkurve eines mit dem erfindungsgemäßen Verfahren in der Amplitude vorverzerrten Eingangssignals dargestellt. In dem in Fig. 9 dargestellten Ausgangsspektrums des Hochfrequenz-Leistungsverstärkers 3 ergibt sich ein deutlich vergrößerter Schulterabstand von 36 dB zwischen dem Nutzsignal und dem Störspektrum. Wie Fig. 10 erkennen läßt, ist die Ansteuer-Kennlinie aufgrund der Vorverzerrung im Vergleich zu Fig. 6 wesentlich besser linearisiert.

Fig. 11 zeigt das Ausgangsspektrum des Hochfrequenz-Leistungsverstärkers 3, wenn neben einer Amplituden-Vorverzerrung zusätzlich eine Phasen-Vorverzerrung vorgenommen wird. Der Schulterabstand zwischen dem Nutzsignal und dem Störspektrum läßt sich auf ca. 40 dB vergrößern. Die in Fig. 12 dargestellte Phasen-Kennlinie zeigt die zugehörige Ausgangsphase, die im Mittel etwa Null ist und wesentlichen geringeren leistungsabhängigen Schwankungen unterworfen ist als die in Fig. 7 für den nicht vorverzerrten Hochfrequenz-Leistungsverstärker 3 dargestellte Phasen-Kennlinie.

**Patentansprüche**

1. Meßverfahren, welches die Verzerrung eines Hochfrequenz-Leistungsverstärkers (3) mit folgenden Verfahrensschritten mißt:

   - Messen eines Eingangssignals (7) und eines zugehörigen Ausgangssignals (6) des Hochfrequenz-Verstärkers (3),
   - Aufteilen des Eingangssignals (7) des Hochfrequenz-Leistungsverstärkers (3) in eine Eingangs-Hüllkurve und einen Referenzträger,
   - Erzeugen einer Ausgangs-Hüllkurve aus dem Ausgangssignal (6) des Hochfrequenz-Verstärkers (3) unter Verwendung des aus dem Eingangssignal erzeugten Referenzträgers, und
   - Anzeigen (13) einer Aussteuer-Kennlinie des Hochfrequenz-Leistungsverstärkers (3) in Form der Amplitude oder Leistung der Ausgangs-Hüllkurve als Funktion der Amplitude oder Leistung der Eingangs-Hüllkurve.

2. Meßverfahren nach Anspruch 1,
**dadurch gekennzeichnet,**
**daß** das Erzeugen der Ausgangs-Hüllkurve mittels Synchrondemodulation (9) erfolgt.

3. Meßverfahren nach Anspruch 1 oder 2,
**dadurch gekennzeichnet,**
**daß** die Eingangs-Hüllkurve aus dem Eingangssignal (7) mittels Synchrondemodulation (8) gewonnen wird.

4. Meßverfahren nach einem der Ansprüche 1 bis 3,
**dadurch gekennzeichnet,**

   **daß** von der Ausgangs-Hüllkurve sowohl eine Inphase-Komponente als auch eine Quadratur-Komponente erzeugt wird, indem der Referenzträger für die Erzeugung der Quadratur-Komponente um 90° in der Phase verschoben wird, und
   **daß** aus der Inphase-Komponente und der Quadratur-Komponente der Phasenwinkel der Ausgangs-Hüllkurve gewonnen und angezeigt wird.

5. Meßverfahren nach Anspruch 4,
**dadurch gekennzeichnet,**
**daß** eine Phasenkennlinie in Form des Phasenwinkels des Ausgangssignals (6) als Funktion der Amplitude oder Leistung der Eingangs-Hüllkurve oder als Funktion der Amplitude oder Leistung der Ausgangs-Hüllkurve angezeigt wird.

**6.** Meßverfahren nach Anspruch 4 oder 5,
**dadurch gekennzeichnet,**
**daß** die Erzeugung der Inphase-Komponente und der Quadratur-Komponente durch getrennte Synchrondemodulation (9, 10) erfolgt.

**7.** Meßverfahren nach einem der Ansprüche 1 bis 6,
**dadurch gekennzeichnet,**
**daß** der Referenzträger vor der Erzeugung der Ausgangs-Hüllkurve um einen Phasenwinkel verschoben wird, der der Signallaufzeitverzögerung durch den Hochfrequenz-Leistungsverstärker (3) entspricht.

**8.** Entzerrungsverfahren, das einen Hochfrequenz-Leistungsverstärkers (3) mit folgenden Verfahrensschritten entzerrt:

- Messen eines Abgleich-Eingangssignals (7) und eines zugehörigen Abgleich-Ausgangssignals (6) des Hochfrequenz-Verstärkers (3) in einem Abgleichmodus,
- Aufteilen (8) des Abgleich-Eingangssignals (7) in eine Eingangs-Hüllkurve und einen Referenzträger,
- Erzeugen (9) einer Ausgangs-Hüllkurve aus dem Abgleich-Ausgangssignal des Hochfrequenz-Verstärkers (3) unter Verwendung des aus dem Abgleich-Eingangssignal erzeugten Referenzträgers,
- Erzeugen (24) eines Amplituden-Korrekturfaktors als Funktion der Amplitude des Eingangssignals, der von dem Verhältnis der Amplituden der Ausgangs-Hüllkurve und der Eingangs-Hüllkurve des in dem Abgleichmodus gemessenen Abgleichsignals abhängig ist, und
- Durchführen einer automatischen Amplitudenvorverzerrung (2), indem die Amplitude des Eingangssignals des Hochfrequenz-Leistungsverstärkers (3) mit dem Amplituden-Korrekturfaktor korrigiert wird.

**9.** Entzerrungsverfahren nach Anspruch 8,
**dadurch gekennzeichnet,**

**daß** von der Ausgangs-Hüllkurve sowohl eine Inphase-Komponente als auch eine Quadratur-Komponente erzeugt wird, indem der Referenzträger für die Erzeugung der Quadratur-Komponente um 90° in der Phase verschoben wird,
**daß** aus der Inphase-Komponente und der Quadratur-Komponente der Phasenwinkel der Ausgangs-Hüllkurve gewonnen wird,
**daß** ein Phasen-Korrekturfaktor als Funktion der Amplitude des Eingangssignals erzeugt wird, der von dem Phasenwinkel der Ausgangs-Hüllkurve des in dem Abgleichmodus gemessenen Abgleichsignals abhängig ist, und
**daß** eine automatische Phasenvorverzerrung (2) durchgeführt wird, indem die Phase des Eingangssignals des Hochfrequenz-Leistungsverstärkers mit dem Phasen-Korrekturfaktor korrigiert wird.

**10.** Entzerrungsverfahren nach Anspruch 9,
**dadurch gekennzeichnet,**
**daß** die Erzeugung der Inphase-Komponente und der Quadratur-Komponente durch getrennte Synchrondemodulation (9, 10) erfolgt.

**11.** Entzerrungsverfahren nach einem der Ansprüche 8 bis 10,
**dadurch gekennzeichnet,**
**daß** der Amplituden-Korrekturfaktor und ggf. der Phasen-Korrekturfaktor einer Vorverzerrungseinrichtung (2) zugeführt werden, deren Aussteuer-Kennlinie und ggf. Phasen-Kennlinie durch den Amplituden-Korrekturfaktor und ggf. den Phasen-Korrekturfaktor in dem Abgleichmodus invers zu der Aussteuer-Kennlinie und ggf. Phasen-Kennlinie des Hochfrequenz-Leistungsverstärkers (3) eingestellt werden.

**12.** Entzerrungsverfahren nach einem der Ansprüche 8 bis 11,
**dadurch gekennzeichnet,**
**daß** die Eingangs-Hüllkurve, die Ausgangs-Hüllkurve bzw. die Inphase-Komponente und die Quadratur-Komponente der Ausgangs-Hüllkurve digitalisiert werden und der Amplituden-Korrekturfaktor und ggf. der Phasen-Korrekturfaktor in einem Steuerrechner (24) berechnet werden.

**13.** Entzerrungsverfahren nach einem der Ansprüche 8 bis 12,
**dadurch gekennzeichnet,**
**daß** das Abgleichsignal ein amplitudenmoduliertes Einfachträgersignal ist.

**14.** Entzerrungsverfahren nach einem der Ansprüche 8 bis 12,
**dadurch gekennzeichnet,**
**daß** das Abgleichsignal ein Multiträgersignal ist, wobei sich sämtliche Träger der Multiträgersignals im gleichen Phasenzustand befinden.

**15.** Entzerrungsverfahren nach einem der Ansprüche 8 bis 14,
**dadurch gekennzeichnet,**
**daß** der Hochfrequenz-Leistungsverstärker (3) modular aus mehreren parallel arbeitenden Teilverstärkern zusammengesetzt ist und daß das Messen des Abgleich-Eingangssignals und des zugehörigen Abgleich-Ausgangssignals in dem Abgleichmodus nur an einem der Teilverstärker erfolgt und der für diesen Teilverstärker erzeugte Amplituden-Korrekturfaktor und ggf. Phasen-Korrekturfaktor für die anderen Teilverstärker übernommen wird.

**16.** Meßeinrichtung (5), die die Verzerrung eines Hochfrequenz-Leistungsverstärkers (3) mißt, mit

- einer Einrichtung, die einen Referenzträger aus einem gemessenen Eingangssignal (7) des Hochfrequenz-Leistungsverstärkers (3) erzeugt,
- einem ersten Synchrondemodulator (8), der eine Eingangs-Hüllkurve aus dem gemessenen Eingangssignal und dem Referenzträger erzeugt,
- einem zweiten Synchrondemodulator (9), der eine Inphase-Komponente einer Ausgangs-Hüllkurve aus dem gemessenen Ausgangssignals (6) des Hochfrequenz-Leistungsverstärkers (3) und dem Referenzträger erzeugt,
- einem Phasenschieber (12), der die Phase des Referenzträgers um 90° verschiebt,
- einem dritten Synchrondemodulator (10), der eine Quadratur-Komponente der Ausgangs-Hüllkurve aus dem gemessenen Ausgangssignal des Hochfrequenz-Leistungsverstärkers (3) und dem um 90° phasenverschobenen Referenzträger erzeugt,
- einer ersten Anzeigeeinrichtung (13), die eine Aussteuer-Kennlinie des Hochfrequenz-Leistungsverstärkers in Form der Amplitude oder Leistung der Ausgangs-Hüllkurve als Funktion der Amplitude oder Leistung der Eingangs-Hüllkurve anzeigt, und/oder
- einer zweiten Anzeigeeinrichtung (18), die eine Phasen-Kennlinie des Hochfrequenz-Leistungsverstärkers in Form des durch das Verhältnis der Quadratur-Komponente zu der Inphase-Komponente gegebenen Phasenwinkels des Ausgangssignals (6) als Funktion der Amplitude oder Leistung der Eingangs-Hüllkurve oder als Funktion der Amplitude oder Leistung der Ausgangs-Hüllkurve anzeigt.

**17.** Entzerrungseinrichtung (5, 20), die einen Hochfrequenz-Leistungsverstärker (3) automatisch entzerrt, mit

- einer Einrichtung, die einen Referenzträger aus einem gemessenen Abgleich-Eingangssignal (7) des Hochfrequenz-Leistungsverstärkers (3) erzeugt,
- einem ersten Synchrondemodulator (8), der eine Eingangs-Hüllkurve aus dem gemessenen Abgleich-Eingangssignal und dem Referenzträger erzeugt,
- einem zweiten Synchrondemodulator (9), der eine Inphase-Komponente einer Ausgangs-Hüllkurve aus einem gemessenen Abgleich-Ausgangssignal des Hochfrequenz-Leistungsverstärkers (3) und dem Referenzträger erzeugt,
- einem Phasenschieber (12), der die Phase des Referenzträgers um 90° verschiebt,
- einem dritten Synchrondemodulator (10), der eine Quadratur-Komponente der Ausgangs-Hüllkurve aus dem gemessenen Ausgangssignal des Hochfrequenz-Leistungsverstärkers (3) und dem um 90° phasenverschobenen Referenzträger erzeugt,
- einer Steuereinrichtung (24), die ein Amplitudenkorrektur-Steuersignal und/oder ein Phasenkorrektur-Steuersignal aus der Eingangs-Hüllkurve, der Inphase-Komponente der Ausgangs-Hüllkurve und/oder der Quadratur-Komponente der Ausgangs-Hüllkurve erzeugt, und
- einer Vorverzerrungseinrichtung (2), deren Aussteuer-Kennlinie und Phasen-Kennlinie durch den Amplituden-Korrekturfaktor und/ oder den Phasen-Korrekturfaktor in dem Abgleichmodus invers zu der Aussteuer-Kennlinie und/oder Phasen-Kennlinie des Hochfrequenz-Leistungsverstärkers (3) eingestellt werden,

wobei die Aussteuer-Kennlinie durch die Amplitude oder Leistung der Ausgangs-Hüllkurve als Funktion der Amplitude oder Leistung der Eingangs-Hüllkurve und die Phasenkennlinie durch den Phasenwinkel des Ausgangssignals (6) als Funktion der Amplitude oder Leistung der Eingangs-Hüllkurve oder als Funktion der Amplitude oder Leistung der Ausgangs-Hüllkurve gegeben sind.

## Claims

**1.** Measuring process that measures the distortion of a high-frequency power amplifier (3), with the following process steps:

- measuring an input signal (7) and an associated output signal (6) of the high-frequency amplifier (3),
- splitting up the input signal (7) of the high-frequency power amplifier (3) into an input envelope and a reference carrier,
- generating an output envelope from the output signal (6) of the high-frequency power amplifier (3) using the reference carrier generated from the input signal, and

- displaying (13) a modulation characteristic of the high-frequency power amplifier (3) in the form of the amplitude or power of the output envelope as a function of the amplitude or power of the input envelope.

**2.** Measuring process according to Claim 1, **characterised in that** the output envelope is generated by means of synchronous demodulation (9).

**3.** Measuring process according to Claim 1 or 2, **characterised in that** the input envelope is acquired from the input signal (7) by means of synchronous demodulation (8).

**4.** Measuring process according to one of Claims 1 to 3, **characterised in that**

both an inphase component and a quadrature component are generated from the output envelope by the reference carrier for the generation of the quadrature component being shifted in its phase by 90°, and
the phase angle of the output envelope is acquired from the inphase component and the quadrature component and is displayed.

**5.** Measuring process according to Claim 4, **characterised in that** a phase characteristic in the form of the phase angle of the output signal (6) is displayed as a function of the amplitude or power of the input envelope or as a function of the amplitude or power of the output envelope.

**6.** Measuring process according to Claim 4 or 5, **characterised in that** generation of the inphase component and of the quadrature component is effected by separate synchronous demodulation (9, 10).

**7.** Measuring process according to one of Claims 1 to 6, **characterised in that** prior to generation of the output envelope the reference carrier is shifted by a phase angle that corresponds to the signal transit-time delay through the high-frequency power amplifier (3).

**8.** Correction process that corrects a high-frequency power amplifier (3), with the following process steps:

- measuring a balancing input signal (7) and an associated balancing output signal (6) of the high-frequency amplifier (3) in a balancing mode,
- splitting up (8) the balancing input signal (7) into an input envelope and a reference carrier,
- generating (9) an output envelope from the balancing output signal of the high-frequency power amplifier (3) using the reference carrier generated from the balancing input signal,
- generating (24) an amplitude-correction factor as a function of the amplitude of the input signal, said amplitude-correction factor being dependent on the ratio of the amplitudes of the output envelope and of the input envelope of the balancing signal measured in the balancing mode, and
- implementing an automatic amplitude predistortion (2) by the amplitude of the input signal of the high-frequency power amplifier (3) being corrected with the amplitude-correction factor.

**9.** Correction process according to Claim 8 **characterised in that**

both an inphase component and a quadrature component are generated from the output envelope by the reference carrier for the generation of the quadrature component being shifted in its phase by 90°,
the phase angle of the output envelope is acquired from the inphase component and the quadrature component,
a phase-correction factor is generated as a function of the amplitude of the input signal, said phase-correction factor being dependent on the phase angle of the output envelope of the balancing signal measured in the balancing mode, and an automatic phase predistortion (2) is implemented by the phase of the input signal of the high-frequency power amplifier being corrected with the phase-correction factor.

**10.** Correction process according to Claim 9, **characterised in that** generation of the inphase component and of the quadrature component is undertaken by separate synchronous demodulation (9, 10).

**11.** Correction process according to one of Claims 8 to 10, **characterised in that** the amplitude-correction factor and optionally the phase-correction factor are supplied to a predistortion device (2), the modulation characteristic of which and optionally the phase characteristic of which are set in the balancing mode by the amplitude-correction factor and optionally the phase-correction factor so as to be inverse in relation to the modulation characteristic and optionally to the phase characteristic of the high-frequency power amplifier (3).

**12.** Correction process according to one of Claims 8 to 11,
**characterised in that**
the input envelope, the output envelope, or to be more exact the inphase component and the quadrature component of the output envelope, are digitized and the amplitude-correction factor and optionally the phase-correction factor are calculated in a control computer (24).

**13.** Correction process according to one of Claims 8 to 12,
**characterised in that**
the balancing signal is an amplitude-modulated single-carrier signal.

**14.** Correction process according to one of Claims 8 to 12,
**characterised in that**
the balancing signal is a multi-carrier signal, all the carriers of the multi-carrier signal being in the same phase state.

**15.** Correction process according to one of Claims 8 to 14,
**characterised in that**
the high-frequency power amplifier (3) is composed in modular manner of several sub-amplifiers operating in parallel and **in that** measurement of the balancing input signal and of the associated balancing output signal in the balancing mode is undertaken only at one of the sub-amplifiers and the amplitude-correction factor generated for this sub-amplifier and optionally the phase-correction factor is adopted for the other sub-amplifiers.

**16.** Measuring device (5) that measures the distortion of a high-frequency power amplifier (3), with

- a device which generates a reference carrier from a measured input signal (7) of the high-frequency power amplifier (3),
- a first synchronous demodulator (8) which generates an input envelope from the measured input signal and the reference carrier,
- a second synchronous demodulator (9) which generates an inphase component of an output envelope from the measured output signal (6) of the high-frequency power amplifier (3) and the reference carrier,
- a phase-shifter (12) which shifts the phase of the reference carrier by 90°,
- a third synchronous demodulator (10) which generates a quadrature component of the output envelope from the measured output signal of the high-frequency power amplifier (3) and the reference carrier that has been phase-shifted by 90°,
- a first display device (13) which displays a modulation characteristic of the high-frequency power amplifier in the form of the amplitude or power of the output envelope as a function of the amplitude or power of the input envelope, and/or
- a second display device (18) which displays a phase characteristic of the high-frequency power amplifier in the form of the phase angle of the output signal (6) given by the ratio of the quadrature component to the inphase component as a function of the amplitude or power of the input envelope or as a function of the amplitude or power of the output envelope.

**17.** Correction device (5, 20) that automatically corrects a high-frequency power amplifier (3), with

- a device which generates a reference carrier from a measured balancing input signal (7) of the high-frequency power amplifier (3),
- a first synchronous demodulator (8) which generates an input envelope from the measured balancing input signal and the reference carrier,
- a second synchronous demodulator (9) which generates an inphase component of an output envelope from a measured balancing output signal of the high-frequency power amplifier (3) and the reference carrier,
- a phase-shifter (12) which shifts the phase of the reference carrier by 90°,
- a third synchronous demodulator (10) which generates a quadrature component of the output envelope from the measured output signal of the high-frequency power amplifier (3) and the reference carrier that has been phase-shifted by 90°,
- a control device (24) which generates an amplitude-correction control signal and/or a phase-correction control signal from the input envelope, from the inphase component of the output envelope and/or from the quadrature component of the output envelope, and
- a predistortion device (2), the modulation characteristic of which and phase characteristic of which are set in the balancing mode by the amplitude-correction factor and/or the phase-correction factor so as to be inverse in relation to the modulation characteristic and/or phase characteristic of the high-frequency power amplifier (3), the modulation characteristic being given by the amplitude or power of the output envelope as a function of the amplitude or power of the input envelope and the phase characteristic being given by the phase angle of the output signal (6) as a function of the amplitude or power of the input envelope or as a function of the amplitude or power of the output envelope.

## Revendications

**1.** Procédé de mesure pour la mesure de la distorsion d'un amplificateur de puissance haute fréquence (3) comportant les étapes de procédé suivantes :

- la mesure d'un signal d'entrée (7) et d'un signal de sortie (6) correspondant de l'amplificateur de puissance haute fréquence (3),
- la répartition du signal d'entrée (7) de l'amplificateur de puissance haute fréquence (3) dans une enveloppante d'entrée et dans un porteur de référence,
- la production d'une enveloppante de sortie à partir du signal de sortie (6) de l'amplificateur de puissance haute fréquence (3) en utilisant le porteur de référence produit à partir du signal d'entrée et
- l'affichage (13) d'une courbe de modulation de l'amplificateur de puissance haute fréquence (3) sous forme d'amplitude ou de puissance de l'enveloppante de sortie comme fonction de l'amplitude ou de la puissance de l'enveloppante d'entrée.

**2.** Procédé de mesure selon la revendication 1 **caractérisé en ce que** la production de l'enveloppante de sortie est obtenue au moyen d'une démodulation synchrone (9).

**3.** Procédé de mesure selon la revendication 1 ou 2 **caractérisé en ce que** l'enveloppante d'entrée est produite à partir du signal d'entrée (7) au moyen d'une démodulation synchrone (8).

**4.** Procédé de mesure selon l'une revendications 1 à 3 **caractérisé en ce que**

à partir de l'enveloppante de sortie on produit aussi bien un composant de phase d'entrée qu'un composant de quadrature en déphasant de 90° le porteur de référence pour obtenir le composant de quadrature et
qu'on obtient et qu'on affiche l'angle de phase de l'enveloppante de sortie à partir du composant de phase d'entrée et du composant de quadrature.

**5.** Procédé de mesure selon la revendication 4 **caractérisé en ce que** une courbe caractéristique de phase sous forme de l'angle de phase du signal de sortie (6) est affichée comme fonction de l'amplitude ou de la puissance de l'enveloppante d'entrée ou comme fonction de l'amplitude ou de la puissance de l'enveloppante de sortie.

**6.** Procédé de mesure selon la revendication 4 ou 5 **caractérisé en ce que** la production du composant de phase d'entrée et du composant de quadrature est obtenue par une démodulation synchrone (9) séparée.

**7.** Procédé de mesure selon l'une revendications 1 à 6 **caractérisé en ce que** le porteur de référence est déphasé avant la production de l'enveloppante de sortie selon un angle de phase qui correspond au retard du temps de propagation du signal à travers l'amplificateur de puissance haute fréquence (3).

**8.** Procédé de correction pour la correction d'un amplificateur de puissance haute fréquence (3) comportant les étapes de procédé suivantes :

- la mesure d'un signal d'entrée (7) de réglage et d'un signal de sortie (6) de réglage correspondant de l'amplificateur de puissance haute fréquence (3) dans un mode de réglage,
- la répartition (8) du signal d'entrée (7) de réglage dans une enveloppante d'entrée et dans un porteur de référence,
- la production (9) d'une enveloppante de sortie à partir du signal de sortie de réglage de l'amplificateur de puissance haute fréquence (3) en utilisant le porteur de référence produit à partir du signal d'entrée de réglage et
- la production (24) d'un facteur de correction d'amplitude comme fonction de l'amplitude du signal d'entrée qui dépend du rapport des amplitudes de l'enveloppante de sortie et de l'enveloppante d'entrée du signal de réglage mesuré dans le mode de réglage et
- la réalisation d'une précorrection automatique (2) d'amplitude en corrigeant l'amplitude du signal d'entrée de l'amplificateur de puissance haute fréquence (3) à l'aide du facteur de correction d'amplitude.

**9.** Procédé de correction selon la revendication 8 **caractérisé en ce que**

à partir de l'enveloppante de sortie on produit aussi bien un composant de phase d'entrée qu'un composant de quadrature en déphasant de 90° le porteur de référence pour obtenir le composant de quadrature,
qu'on obtient et qu'on affiche l'angle de phase de l'enveloppante de sortie à partir du composant de phase d'entrée et du composant de quadrature,
qu'on produit un facteur de correction de phase comme fonction de l'amplitude du signal d'entrée qui dépend de l'angle de phase de l'enveloppante de sortie du signal de réglage mesuré dans le mode de réglage et
qu'on réalise une précorrection automatique (2) de phase en corrigeant la phase du signal d'entrée de l'amplificateur de puissance haute fréquence à l'aide du facteur de correction de phases.

**10.** Procédé de correction selon la revendication 9
**caractérisé en ce que**
la production du composant de phase d'entrée et du composant de quadrature est réalisée par une démodulation synchrone (9, 10) séparée.

**11.** Procédé de correction selon l'une des revendications 8 à 10
**caractérisé en ce que**
sont réalisés le facteur de correction d'amplitudes et éventuellement le facteur de correction de phases d'un dispositif de précorrection (2) dont la courbe caractéristique de modulation et éventuellement la courbe caractéristique de phase sont réglées par le facteur de correction d'amplitudes et éventuellement le facteur de correction de phases dans le mode de réglage inversement à la courbe de réglage et éventuellement la courbe de phase de l'amplificateur de puissance haute fréquence (3).

**12.** Procédé de correction selon l'une des revendications 8 à 11
**caractérisé en ce que**
l'enveloppante d'entrée, l'enveloppante de sortie ou le composant de phase d'entrée et le composant de quadrature de l'enveloppante de sortie sont numérisés et que le facteur de correction d'amplitude et éventuellement le facteur de correction de phase sont calculés dans un ordinateur de contrôle (24).

**13.** Procédé de correction selon l'une des revendications 8 à 12
**caractérisé en ce que**
le signal d'égalisation est un signal porteur simple modulé en amplitude.

**14.** Procédé de correction selon l'une des revendications 8 à 12
**caractérisé en ce que**
le signal d'égalisation est un signal porteur multiple, tous les porteurs des signaux porteurs multiples se trouvant dans le même état de phase.

**15.** Procédé de correction selon l'une des revendications 8 à 14
**caractérisé en ce que**
l'amplificateur de puissance haute fréquence (3) est composé modulairement de plusieurs amplificateurs partiels fonctionnant en parallèle et que la mesure du signal d'entrée de réglage et du signal de sortie de réglage correspondant est réalisée dans le module de réglage uniquement sur l'un des amplificateurs partiels et que le facteur de correction d'amplitude et éventuellement le facteur de correction de phase produit pour cet amplificateur partiel sert pour les autres amplificateurs partiels.

**16.** Dispositif de mesure (5) pour la mesure de la distorsion d'un amplificateur de puissance haute fréquence (3) comportant :

- un dispositif qui produit un porteur de référence à partir d'un signal d'entrée (7) mesuré de l'amplificateur de puissance haute fréquence (3),
- un premier démodulateur synchrone (8) qui produit une enveloppante d'entrée à partir du signal d'entrée mesuré et du porteur de référence,
- un deuxième démodulateur synchrone (9) qui produit un composant de phase d'entrée d'une enveloppante de sortie à partir d'un signal de sortie (6) mesuré de l'amplificateur de puissance haute fréquence (3) et à partir du porteur de référence,
- un déphaseur (12) qui déphase de 90° la phase du porteur de référence,
- un troisième démodulateur synchrone (10) qui produit un composant de quadrature de l'enveloppante de sortie à partir du signal de sortie mesuré de l'amplificateur de puissance haute fréquence (3) et à partir du porteur de référence déphasé de 90°,
- un premier dispositif d'affichage (13) qui affiche une courbe caractéristique de modulation de l'amplificateur de puissance haute fréquence sous forme de l'amplitude ou de la puissance de l'enveloppante de sortie comme fonction de l'amplitude ou de la puissance de l'enveloppante d'entrée et/ou
- un deuxième dispositif d'affichage (18) qui affiche une courbe caractéristique de phase de l'amplificateur de puissance haute fréquence sous la forme de l'angle de phase du signal d'entrée (6), lequel angle est obtenu par le rapport du composant de quadrature et du composant de phase d'entrée comme fonction de l'amplitude ou de la puissance de l'enveloppante d'entrée ou comme fonction de l'amplitude ou de la puissance de l'enveloppante de sortie.

**17.** Dispositif de correction (5, 20) pour la correction automatique d'un amplificateur de puissance haute fréquence (3) comportant :

- un dispositif qui produit un porteur de référence à partir d'un signal d'entrée de réglage mesuré (7) de l'amplificateur de puissance haute fréquence (3),
- un premier démodulateur synchrone (8) qui produit une enveloppante d'entrée à partir du signal d'entrée de réglage mesuré et à partir du porteur de référence,
- un deuxième démodulateur synchrone (9) qui produit un composant de phase d'entrée d'une enveloppante de sortie à partir d'un signal de sortie (6) de réglage mesuré de l'amplificateur de puissance haute fréquence (3) et à partir du porteur de référence,
- un déphaseur (12) qui déphase la phase du porteur de référence de 90°,
- un troisième démodulateur synchrone (10) qui produit un composant de quadrature de l'enveloppante de sortie à partir du signal de sortie mesuré de l'amplificateur de puissance haute fréquence (3) et à partir du porteur de référence déphasé de 90°,
- un dispositif de commande (24) qui produit un signal de commande pour la correction de l'amplitude et/ou un signal de commande pour la correction de la phase à partir de l'enveloppante d'entrée, du composant de phase d'entrée de l'enveloppante de sortie et/ou du composant de quadrature de l'enveloppante de sortie et
- un dispositif de précorrection (2) dont la courbe caractéristique de modulation et la courbe caractéristique de phase sont réglées par le facteur de correction d'amplitudes et/ou le facteur de correction de phases dans le mode de réglage inversement à la courbe de modulation et/ou à la courbe de phase de l'amplificateur de puissance haute fréquence (3),

la courbe de modulation étant déterminée par l'amplitude ou par la puissance de l'enveloppante de sortie comme fonction de l'amplitude ou de la puissance de l'enveloppante d'entrée, et la courbe de phase par l'angle de phase du signal de sortie (6) comme fonction de l'amplitude ou de la puissance de l'enveloppante d'entrée ou comme fonction de l'amplitude ou de la puissance de l'enveloppante de sortie.

FIG.1

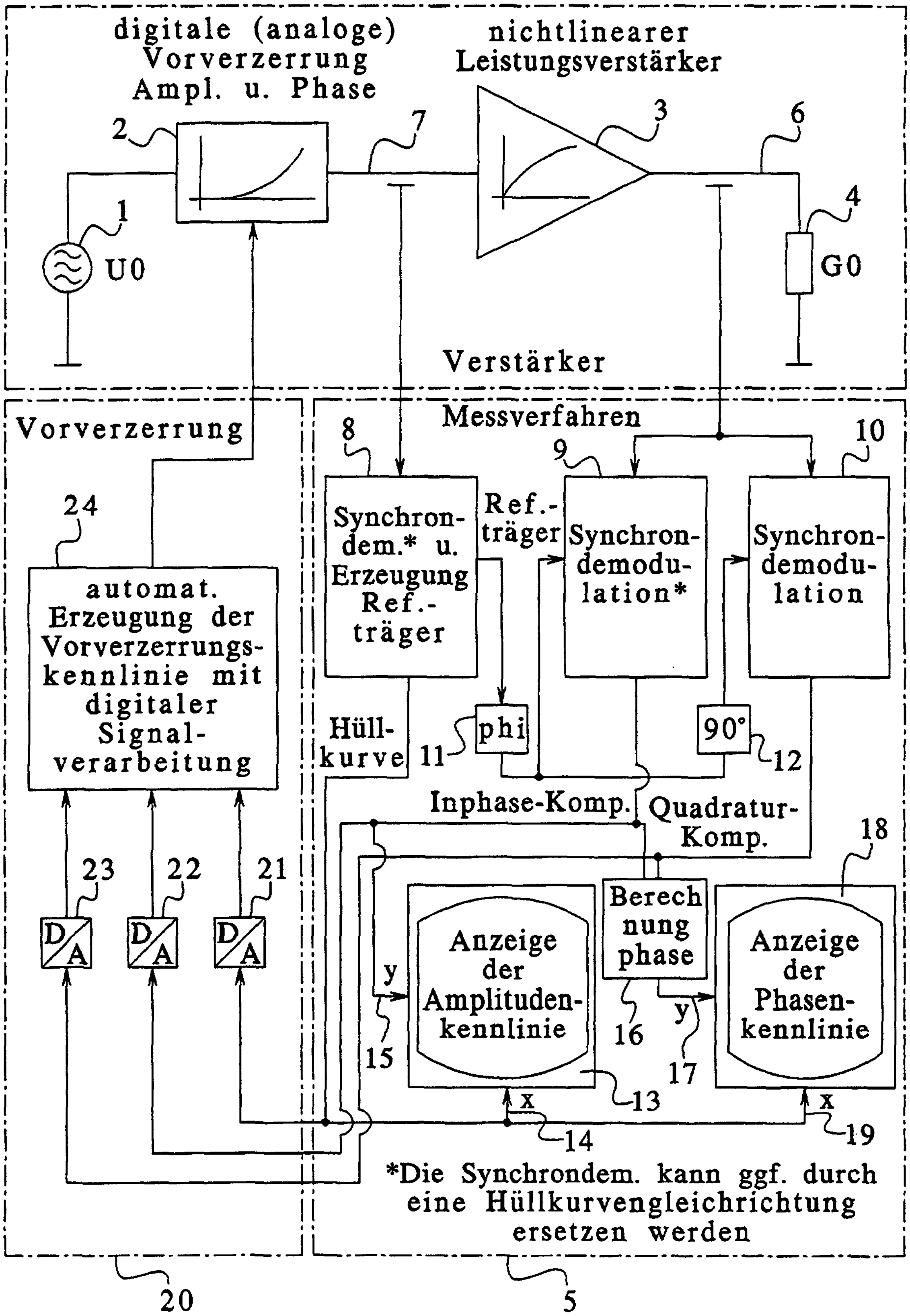
digitale (analoge) Vorverzerrung Ampl. u. Phase
nichtlinearer Leistungsverstärker
2
7
3
6
1
U0
4
G0
Verstärker
Vorverzerrung
Messverfahren
8
9
10
24
Synchron-dem.* u. Erzeugung Ref.-träger
Ref.-träger
Synchron-demodulation*
Synchron-demodulation
automat. Erzeugung der Vorverzerrungs-kennlinie mit digitaler Signal-verarbeitung
Hüll-kurve
11
phi
90°
12
Inphase-Komp.
Quadratur-Komp.
18
23
22
21
D/A
D/A
D/A
Berechnung phase
Anzeige der Amplituden-kennlinie
Anzeige der Phasen-kennlinie
y
y
15
16
17
13
x
x
14
19
*Die Synchrondem. kann ggf. durch eine Hüllkurvengleichrichtung ersetzen werden
20
5

FIG.2

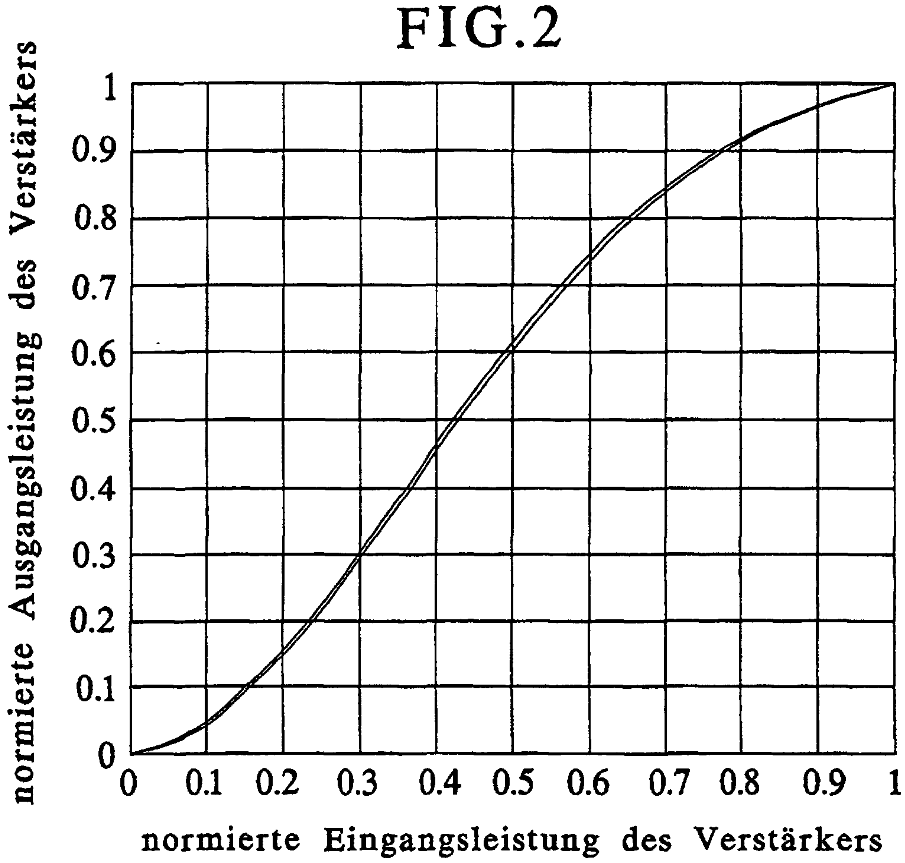
normierte Ausgangsleistung des Verstärkers
1
0.9
0.8
0.7
0.6
0.5
0.4
0.3
0.2
0.1
0
0 0.1 0.2 0.3 0.4 0.5 0.6 0.7 0.8 0.9 1
normierte Eingangsleistung des Verstärkers

FIG.3

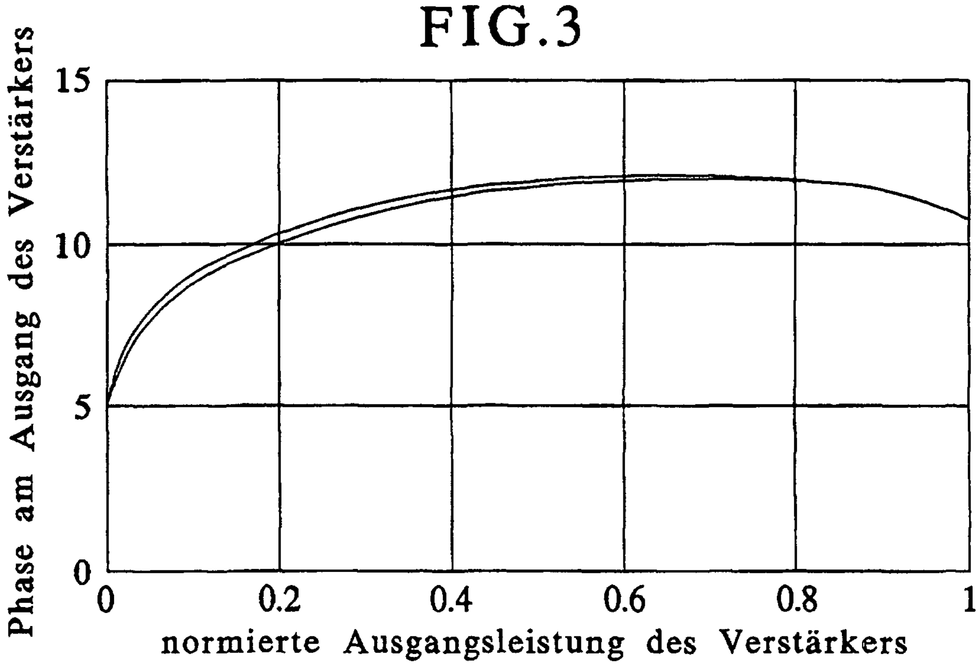
Phase am Ausgang des Verstärkers
15
10
5
0
0 0.2 0.4 0.6 0.8 1
normierte Ausgangsleistung des Verstärkers

FIG.4

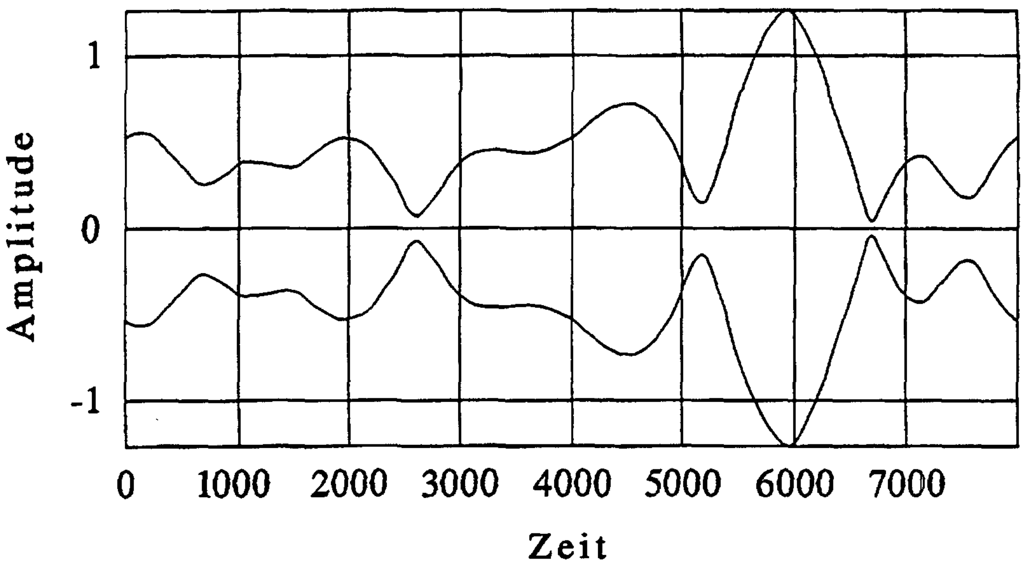
Amplitude
1
0
-1
0
1000
2000
3000
4000
5000
6000
7000
Zeit

FIG.5

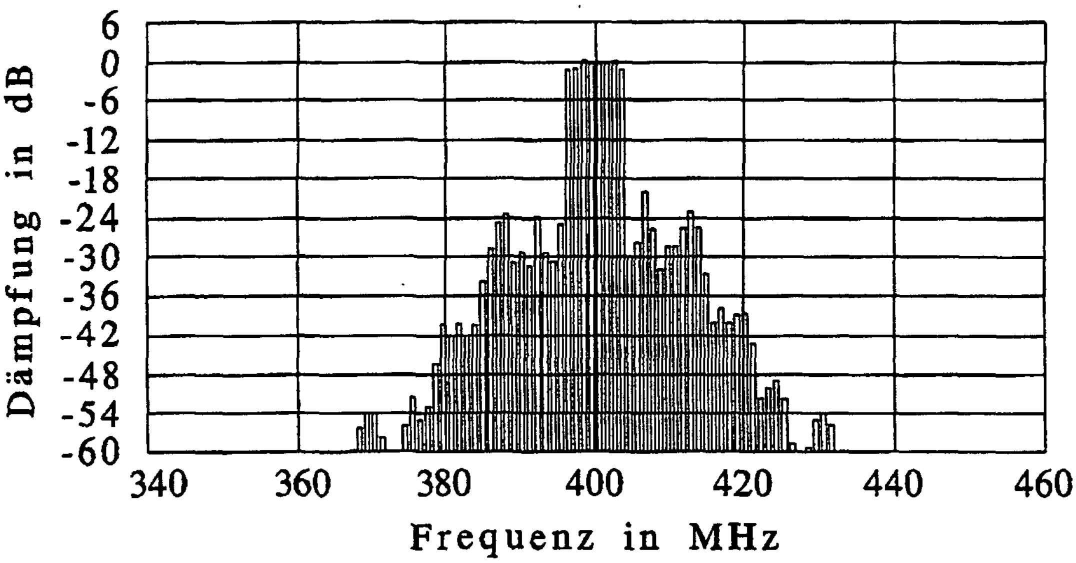
Dämpfung in dB
6
0
-6
-12
-18
-24
-30
-36
-42
-48
-54
-60
340
360
380
400
420
440
460
Frequenz in MHz

FIG.6

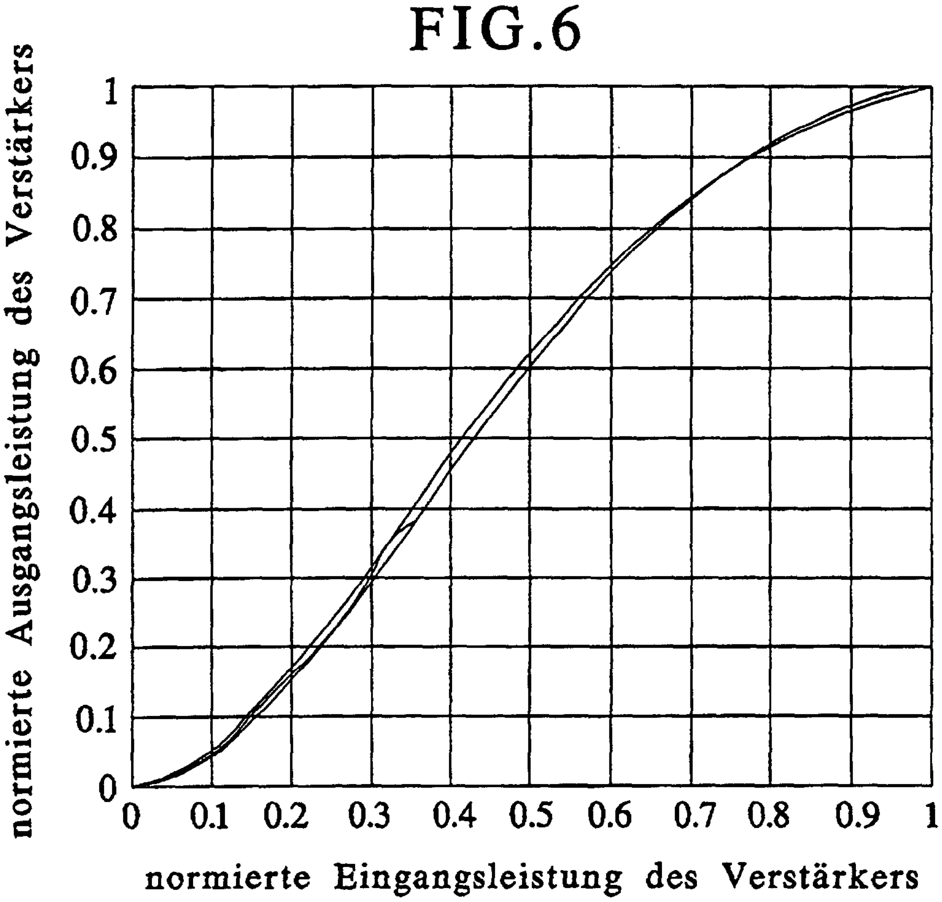
normierte Ausgangsleistung des Verstärkers
1
0.9
0.8
0.7
0.6
0.5
0.4
0.3
0.2
0.1
0
0 0.1 0.2 0.3 0.4 0.5 0.6 0.7 0.8 0.9 1
normierte Eingangsleistung des Verstärkers

FIG.7

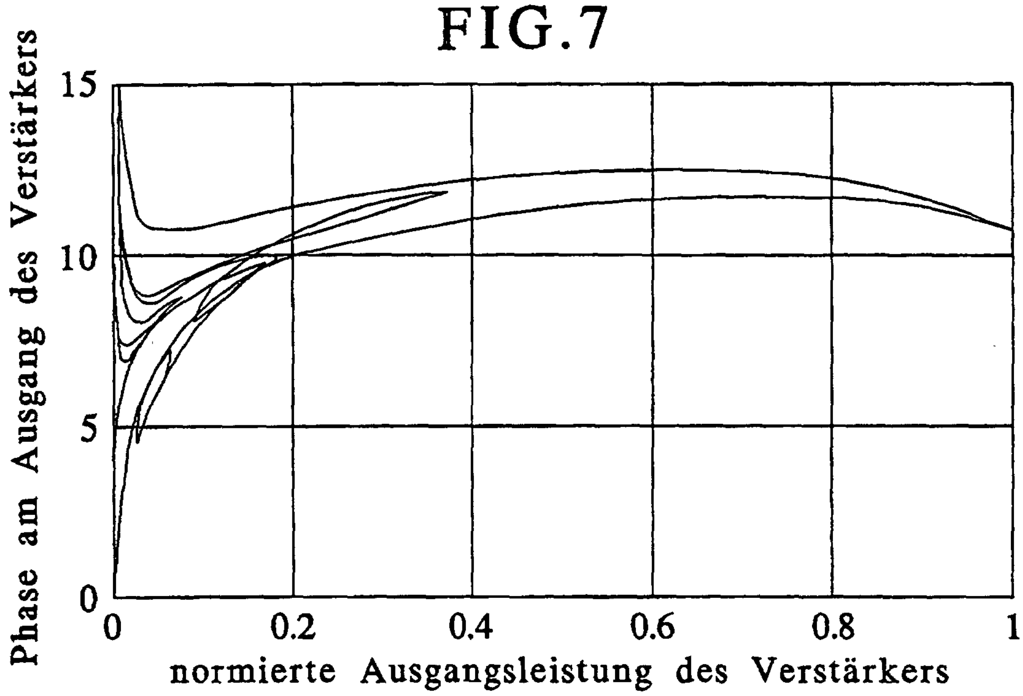
Phase am Ausgang des Verstärkers
15
10
5
0
0 0.2 0.4 0.6 0.8 1
normierte Ausgangsleistung des Verstärkers

# FIG.8

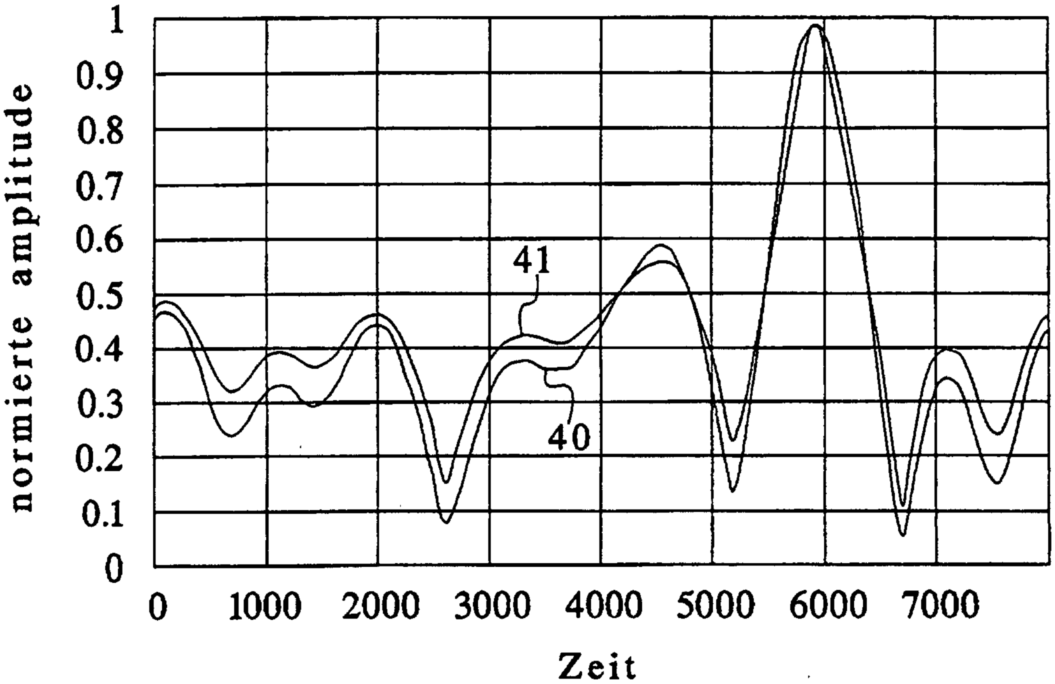
1
0.9
0.8
0.7
0.6
0.5
0.4
0.3
0.2
0.1
0
normierte amplitude
41
40
0
1000
2000
3000
4000
5000
6000
7000
Zeit

# FIG.9

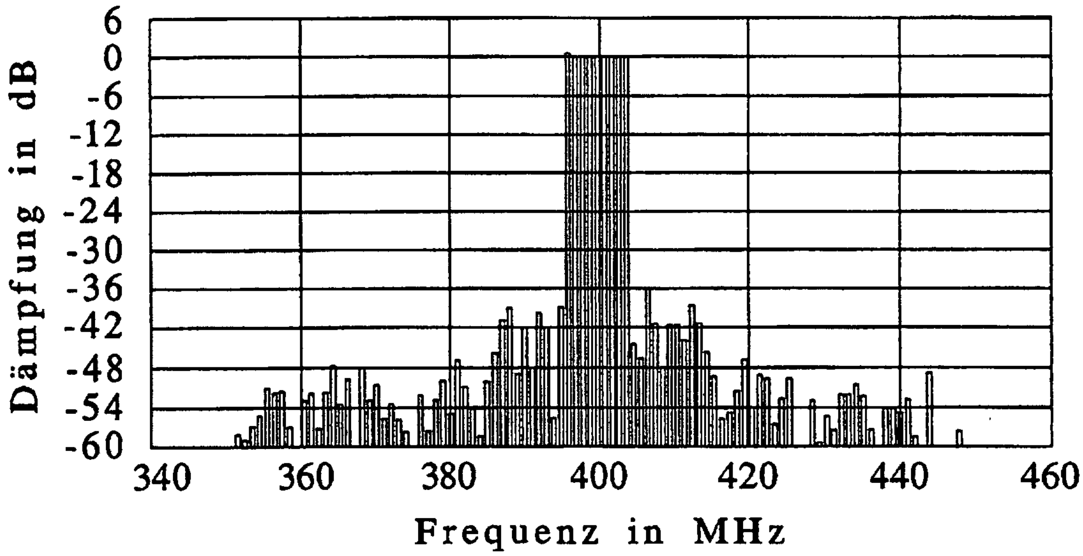
6
0
-6
-12
-18
-24
-30
-36
-42
-48
-54
-60
Dämpfung in dB
340
360
380
400
420
440
460
Frequenz in MHz

FIG.10

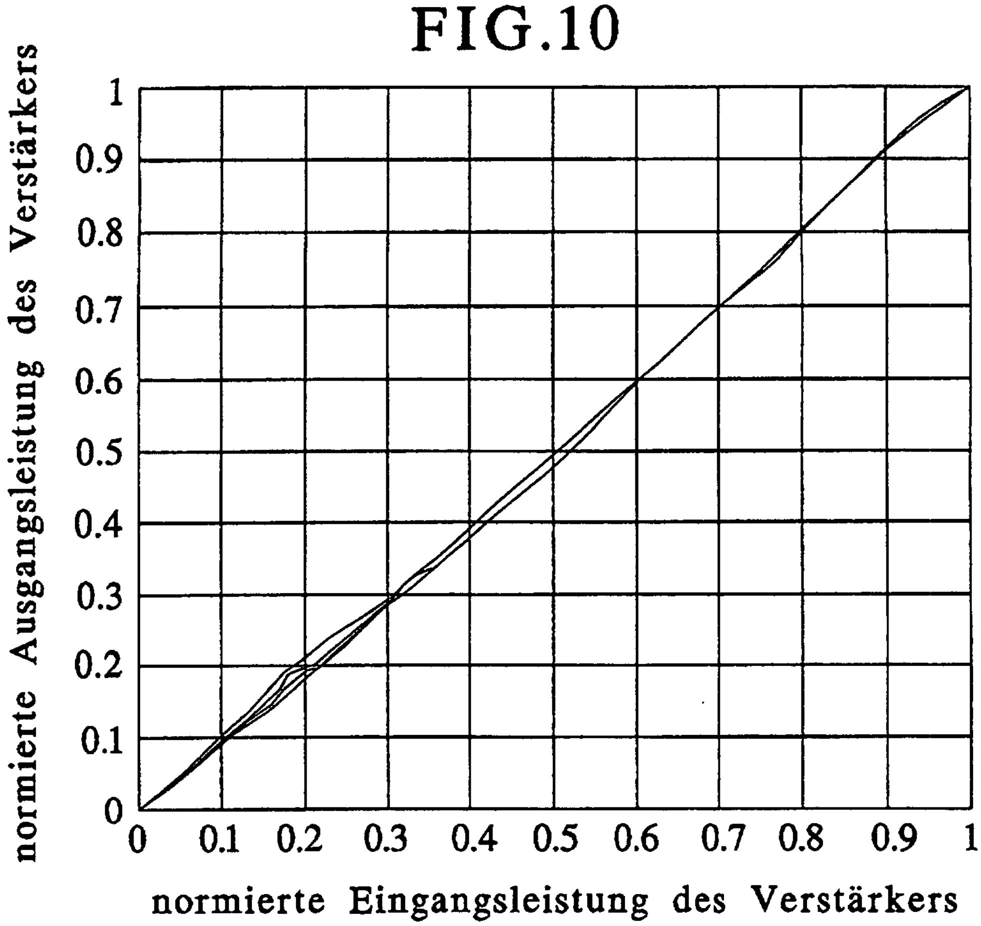
normierte Ausgangsleistung des Verstärkers
1
0.9
0.8
0.7
0.6
0.5
0.4
0.3
0.2
0.1
0
0 0.1 0.2 0.3 0.4 0.5 0.6 0.7 0.8 0.9 1
normierte Eingangsleistung des Verstärkers

FIG.11

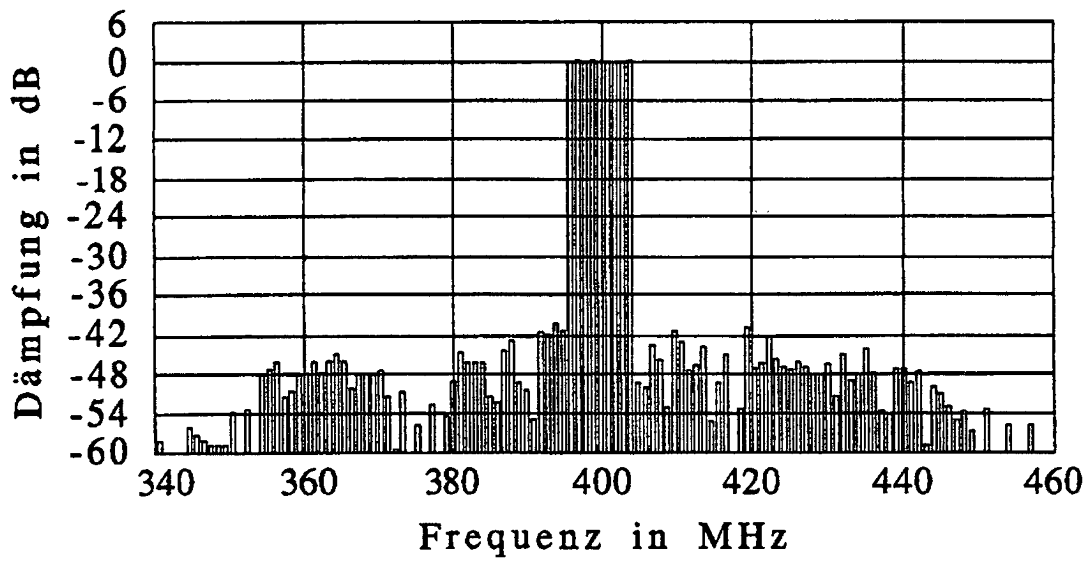
Dämpfung in dB
6
0
-6
-12
-18
-24
-30
-36
-42
-48
-54
-60
340 360 380 400 420 440 460
Frequenz in MHz

FIG.12

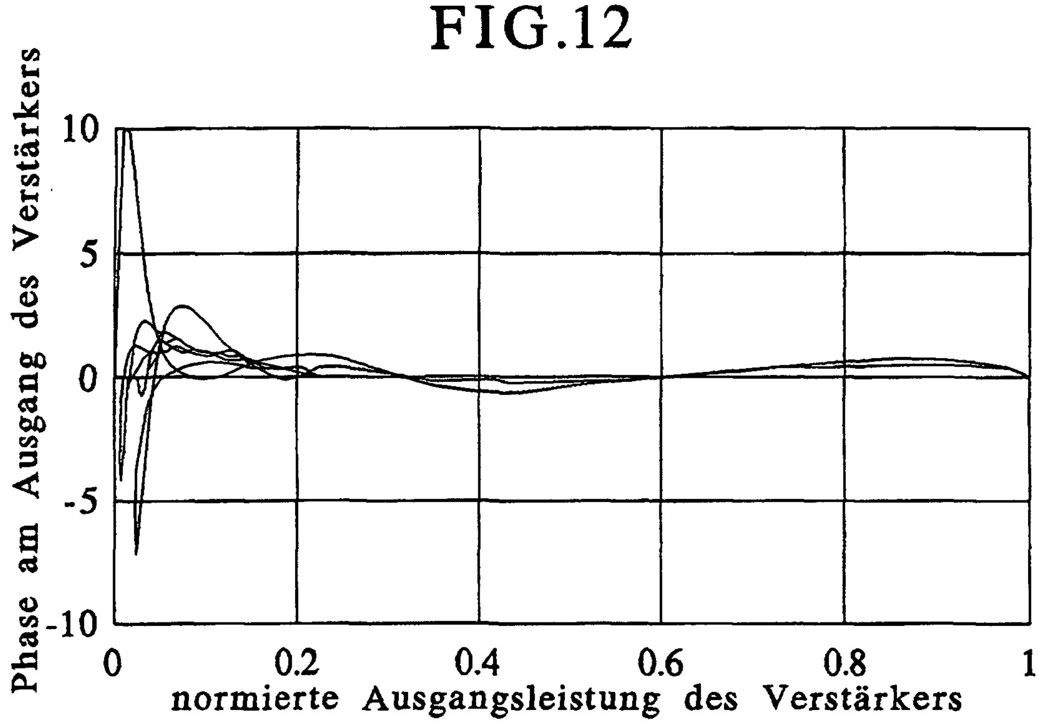
Phase am Ausgang des Verstärkers
10
5
0
-5
-10
0
0.2
0.4
0.6
0.8
1
normierte Ausgangsleistung des Verstärkers

FIG.13

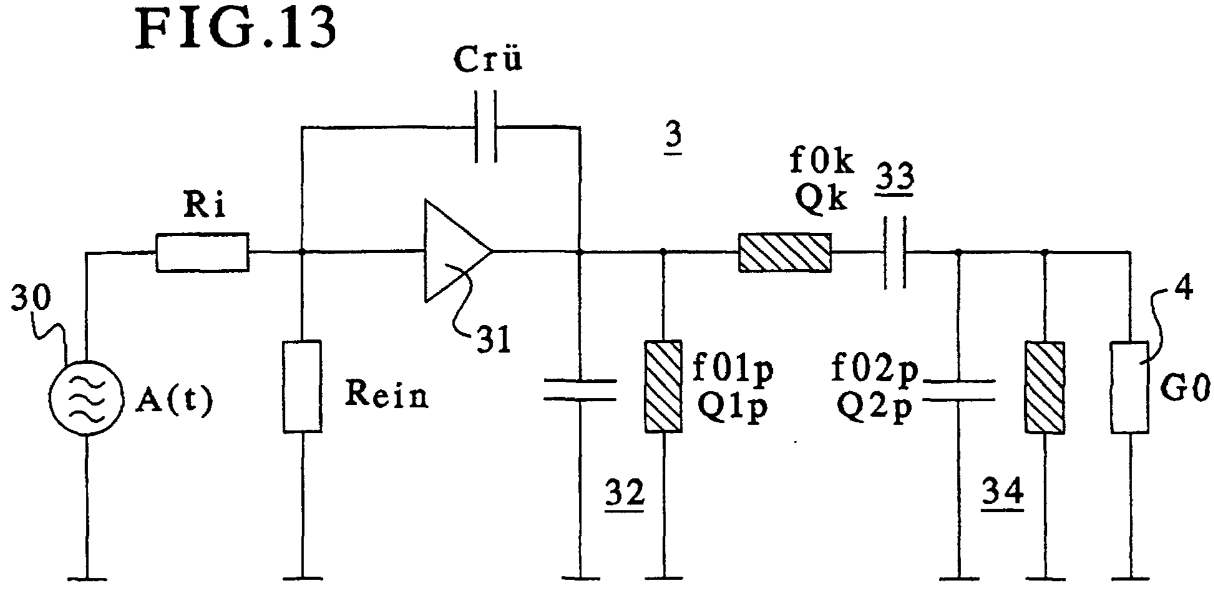
Crü
3
f0k
Qk
33
Ri
30
A(t)
Rein
31
f01p
Q1p
f02p
Q2p
32
34
4
G0